(19) Europäisches Patentamt
European Patent Office
Office européen des brevets

(11) EP 4 464 477 B1

(12) **EUROPEAN PATENT SPECIFICATION**

(45) Date of publication and mention of the grant of the patent:
**17.06.2026 Bulletin 2026/25**

(21) Application number: **23174333.7**

(22) Date of filing: **19.05.2023**

(51) International Patent Classification (IPC):
***B26B 21/60*** (2006.01) ***B26B 21/56*** (2006.01)
***B05D 1/00*** (2006.01) ***B05D 5/08*** (2006.01)
***B05D 7/00*** (2006.01) ***C23C 14/06*** (2006.01)
***C23C 14/16*** (2006.01) ***C23C 16/02*** (2006.01)
***C23C 16/56*** (2006.01) *B05D 3/02* (2006.01)
*B05D 3/04* (2006.01) *B05D 7/14* (2006.01)

(52) Cooperative Patent Classification (CPC):
**B26B 21/60; B05D 1/60; B05D 5/08; B05D 7/51; B26B 21/56; C23C 14/067; C23C 14/165; C23C 16/0281; C23C 16/56;** B05D 3/0254; B05D 3/0493; B05D 7/14; B05D 2202/15; B05D 2350/63; B05D 2350/65; (Cont.)

# (54) RAZOR BLADE COMPRISING PARYLENE C AND PARYLENE N

RASIERKLINGE MIT PARYLEN C UND PARYLEN N

LAME DE RASOIR COMPRENANT DU PARYLÈNE C ET DU PARYLÈNE N

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**20.11.2024 Bulletin 2024/47**

(73) Proprietor: **BIC Violex Single Member S.A.**
**145 69 Anoixi (GR)**

(72) Inventors:
- **PANDIS, Christos**
  **145 69 Anoixi (GR)**
- **TSIAKATOURAS, Georgios**
  **145 69 Anoixi (GR)**

(74) Representative: **Peterreins Schley**
**Patent- und Rechtsanwälte PartG mbB**
**Hermann-Sack-Straße 3**
**80331 München (DE)**

(56) References cited:
**US-A- 4 950 365**
**US-A- 5 869 135**
**US-A1- 2017 113 359**
**US-A1- 2020 316 803**
**US-A1- 2023 066 180**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
B05D 2401/33

## Description

### Technical Field

The present invention relates to the field of razor blades. More specifically, the present invention relates to razor blades comprising lubrication layers.

### Background

Razor heads (also known as safety razor heads, razor cartridges or safety razor cartridges) are usually part of a shaving razor assembly that includes a razor handle. A razor head typically comprises one or more cutting members, each including a razor blade, and being arranged between a leading longitudinal side and a trailing longitudinal side of the razor head. In use, a user holds the razor handle in a shaving direction and brings the razor head into contact with a portion of skin. By movement of the razor head in a shaving direction, unwanted hair is removed.

Razor blades for razor cartridges typically comprise a lubrication layer. As the lubrication layers are typically applied by coating, they may also be referred to as lubrication coating. The lubrication layer is intended to reduce the required cutting force during the shaving process. By reducing the required cutting force, the razor may exhibit improved glide during the shaving action, which in turn would facilitate the razor's use. Additionally, reducing the required cutting force may result in lesser pulling on the hair and thereby hair follicles, which may result in discomfort to the user. Furthermore, the lubrication layer may also reduce the friction between the razor blade and the user's skin, which may also improve the razor's glide. Furthermore, the reduced required cutting force and improved glide may result in improved shaving result, e.g. less stubbles, nicks and cuts.

Typically, lubricating coatings for razor blades are made of a perfluoro- or a polyfluoroalkyl substance (PFAS) such as polytetrafluoroethylene (PTFE). PTFE coated razor blades are effective in cutting through hair, show little friction on the skin, as well as a low degree of pulling on the hair.

However, PTFE coatings may also experience drawbacks. First, PTFE coatings are typically applied by spraying PTFE particles onto a razor blade and subsequently sintering those particles at temperatures above the melting point of PTFE. The resulting coating may lack uniformity, which in turn may result in a reduced shaving performance of the razor blades. Further, the increased temperatures during the sintering step may reduce the hardness and corrosion resistance of the razor blade. Finally, PTFE is a highly persistent material and is therefore the subject of environmental concerns.

US 2020/316803 A1 discloses a razor blade comprising a lubricating layer, which may also be a parylene. It discloses top layers as such on the razor blade improving adhesion of the polymer coating layer.

US 2017/113359 A1 discloses a cutting blade of a first material optionally coated with a second material.

In longer lists of the first and second materials, steel, titanium and parylene as such are mentioned, respectively.

US 4 950 365 A discloses a selective parylene coating as such and the example refers to a titanium adhesion layer on a gold substrate.

US 2023/066180 A1 discloses parylene coatings on tools as such and mentions parylene C and parylene N singly as possibilities. The example covers a screwdriver, and the application is focussed on the prevention of corrosion.

US 5 869 135 A discloses a shaving foil for an electric shaver coated with a parylene coating. The description names various types of parylene coatings, including parylene C and parylene N as single layers among a list of possibilities.

The present disclosure aims to address one or more of the aforementioned issues in optimizing lubrication layers.

### Summary

In a first aspect, the present disclosure relates to a razor blade with a lubrication layer provided thereon, wherein the lubrication layer comprises Parylene C and Parylene N, wherein the razor blade comprises a cutting edge portion and the lubrication layer is provided on the cutting edge portion.

In some embodiments, the razor blade may be configured to be disposed within a razor cartridge.

In some embodiments, the lubrication layer may comprise a first layer and a second layer, wherein the first layer may comprise Parylene C and the second layer may comprise Parylene N.

In some embodiments, a hard coating may be additionally provided on the razor blade, wherein the hard coating comprises a ceramic, a metal and/or a non-metallic coating.

In some embodiments, the ceramic may comprise a boride and/or a carbide and in particular titanium diboride.

In some embodiments, the ceramic may comprise titanium, boron and carbon.

In some embodiments, the non-metallic coating may comprise diamond-like-carbon.

In some embodiments, the metal of the hard coating may comprise chromium.

In some embodiments, a capping layer may be additionally provided on the razor blade.

In some embodiments, the capping layer may comprise a metal, even more specifically may comprise chromium or titanium and in particular the capping layer may comprise titanium.

In some embodiments, the capping layer may be disposed between the hard coating and the lubrication layer.

In some embodiments, the capping layer may be disposed directly on the razor blade and the lubrication layer may be disposed on the capping layer.

In some embodiments, the capping layer may be disposed directly on the razor blade, the first layer may be disposed on the capping layer and the second layer may be disposed on the first layer.

In some embodiments, the first layer may be disposed on the capping layer and the second layer may be disposed on the first layer.

In some embodiments, the capping layer may have a thickness between about 5 nm to about 70 nm, more specifically between about 10 nm to about 60 nm and in particular between about 20 nm to about 50 nm.

In some embodiments, the lubrication layer may have a thickness between about 0.005 μm to about 5 μm, more specifically between about 0.02 μm to about 2 μm and in particular between about 0.1 μm to about 1 μm.

In some embodiments, the lubrication layer may comprise no holes, in particular no holes with a diameter of between about 5 nm to about 200 nm.

In some embodiments, the lubrication layer may comprise less than 1 wt.-%, more specifically less than 0.1 wt.-% and in particular no or substantially no polytetrafluoroethylene.

In some embodiments, the razor blade may comprise an intermediate layer between the hard coating and the razor blade, wherein the intermediate layer may comprise a metal, more specifically niobium and/or titanium, even more specifically titanium and in particular metallic titanium.

In some embodiments, the intermediate layer may be provided directly on the razor blade. Alternatively, in some embodiments, the hard coating may be provided directly on the razor blade.

In some embodiments, the razor blade comprises, essentially consists or consists of a metal, in particular a stainless steel.

In some embodiments, the cross-section of the cutting edge portion may have a substantially symmetrical tapering geometry terminating in a blade tip, wherein the cross-section may have a central longitudinal axis originating from the blade tip, and wherein the cutting edge portion may have a thickness of between 1.5 μm and 2.4 μm measured at a distance of 5 μm along the central longitudinal axis from the blade tip.

In a second aspect, the present disclosure relates to a razor cartridge comprising at least one razor blade according to the first aspect.

In a third aspect, the present disclosure relates to a method for coating a razor blade, wherein the method comprises coating a razor blade with Parylene C, more specifically by chemical vapor deposition, and coating the razor blade with Parylene N, more specifically by chemical vapor deposition.

In some embodiments, coating the razor blade with Parylene C may be performed prior to coating the razor blade with Parylene N.

In some embodiments, the method may comprise coating the razor blade with titanium prior to coating the razor blade with Parylene C and/or Parylene N.

In some embodiments, coating the razor blade with Parylene C by chemical vapor deposition may comprise sublimating a dimer of a Parylene C precursor, pyrolyzing the sublimated dimer of a Parylene C precursor to attain Parylene C precursor monomers, and depositing the Parylene C precursor monomers on the razor blade.

In some embodiments, sublimating the dimer of a Parylene C precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a Parylene C precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the Parylene C precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, coating the razor blade with Parylene N by chemical vapor deposition may comprise sublimating a dimer of a Parylene N precursor, pyrolyzing the sublimated dimer of a Parylene N precursor to attain Parylene N precursor monomers, and depositing the Parylene N precursor monomers on the razor blade.

In some embodiments, sublimating the dimer of a Parylene N precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a Parylene N precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the Parylene N precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, the method for coating a

razor blade may further comprise an annealing step, in particular the razor blade may be annealed at a temperature between about 300 °C to about 400 °C, more specifically at a temperature between about 330 °C to about 370 °C in an inert gas atmosphere, in particular after deposition of the Parylene C and/or Parylene N.

In some embodiments, the razor blade may be annealed for a duration between about 10 s to about 20 min, more specifically between about 1 min to about 5 min.

## Brief Description of the Figures

**Fig. 1** is a schematic drawing of a razor blade's edge portion in cross-sectional view, wherein a lubrication coating is provided on the edge portion comprising Parylene N and Parylene C.

**Fig. 2** is a schematic drawing of a razor blade's edge portion in cross-sectional view, wherein a lubrication coating comprising Parylene N and Parylene C is provided on the blade's edge portion on top of an intermediate layer, hard coating and capping layer.

**Fig. 3** is a schematic drawing of a razor blade's edge portion in cross-sectional view, wherein a lubrication coating comprising Parylene N and Parylene C is provided on the blade's edge portion on top of a capping layer.

**Fig. 4** shows a comparison of the cutting force of the first sample lot, with the first, second and third comparative sample lot.

**Fig. 5** shows a comparison of the cutting force of the first sample lot with the second sample lot.

**Fig. 6** shows a comparison of the cutting force of the first sample lot with the third sample lot.

## Detailed Description

Hereinafter, a detailed description will be given of the present disclosure. The terms or words used in the description and the aspects of the present disclosure are not to be construed limitedly as only having common-language or dictionary meanings and should, unless specifically defined otherwise in the following description, be interpreted as having their ordinary technical meaning as established in the relevant technical field. The detailed description will refer to specific embodiments to better illustrate the present disclosure, however, it should be understood that the presented disclosure is not limited to these specific embodiments.

As mentioned above, typically lubricating coatings for razor blades are made of a perfluoro- or a polyfluoroalkyl substance (PFAS) such as polytetrafluoroethylene (PTFE), as PTFE coated razor blades are effective in cutting through hair, show little friction on the skin, as well as low pulling on the hair.

However, PTFE coatings may lack uniformity as a result of deposition by spraying particles, which in turn may result in a reduced shaving performance of the razor blades. Further, the increased temperatures (for prolonged times) during the sintering step may reduce the hardness and corrosion resistance of the razor blade. Additionally, PTFE is a highly persistent material and is therefore the subject of environmental concerns.

A currently emerging alternative to PTFE coatings (or any other PFAS coating), are coatings comprising polymers selected from the group of parylenes, which also show a low coefficient of friction.

It has been surprisingly found that coating a razor blade with a combination of Parylene C and Parylene N may result in a low cutting force, in particular a reduced cutting force compared to either a lubrication layer comprising Parylene C, Parylene N or Parylene F alone.

Accordingly, in a first aspect, the present disclosure relates to a razor blade with a lubrication layer provided thereon, wherein the lubrication layer comprises Parylene C and Parylene N.

The term "parylene" refers to a polymer whose backbone consists of para-benzenediyl rings - $C_6H_4$ connected by 1,2-ethanediyl bridges $-CH_2-CH_2-$. Substitution of the para-benzenediyl rings results in different types of parylenes.

Parylene N (or Parylene N) is an un-substituted parylene. Parylene N may be obtained by polymerization of para-xylylene. Parylene N consists of the following repeating unit:

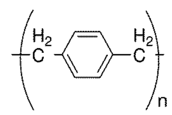

Parylene C (or Parylene C) is a chlorinated-parylene. Parylene C may be obtained by polymerization of 2,8-Dichlorotricyclo[8.2.2.24,7]hexadeca-1(12),4,6,10,13,15-hexaene. Parylene C consists of the following repeating unit:

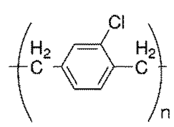

In some embodiments, the razor blade comprises, essentially consists or consists of a metal, in particular a stainless steel. Stainless steel razor blades may exhibit high strength, hardness and corrosion resistance. Further, stainless steel razor blades may be easier to process compared to for example ceramic razor

blades. The razor blade may have undergone grinding to form an edge. More specifically, the razor blade may be shaped such that it terminates in a cutting edge portion having substrate sides which converge towards a substrate edge. Accordingly, in some embodiments, the razor blade may comprise a cutting edge portion and the lubrication layer may be provided on the cutting edge portion.

When referring to a cutting edge portion which is provided with a lubrication layer, it should be understood that such reference does not merely refer to the strict geometrical edge of the razor blade but rather to the edge in view of the cutting action it performs. Accordingly, the term cutting edge portion is also meant to encompass those parts of the razor blade sides which are immediately adj acent to the strict geometrical edge of the cutting edge portion. In exemplary embodiments, the region forming the cutting edge portion extends away from the strict geometric edge of the cutting edge portion along a central longitudinal axis of the cutting edge portion for a distance of: about 5 μm or less, about 10 μm or less, about 15 μm or less, about 25 μm or less, about 50 μm or less, about 75 μm or less, about 100 μm or less, about 125 μm or less, about 150 μm or less, about 175 μm or less, or about 200 μm or less. The lubrication layer may generally follow the surface and contour of the underlying cutting edge portion. In particular, the lubrication layer may form the outermost layer disposed on the razor blade. Accordingly, the lubrication layer may form the blade's edge.

In some embodiments, the razor blade may be configured to be disposed within a razor cartridge. The use of lubrication layers may be particularly beneficial for razor blades used in razor cartridges.

In some embodiments, the lubrication layer may consist, or essentially consist of Parylene C and Parylene N. In some embodiments, the lubrication layer may comprise a first layer and a second layer, wherein the first layer may comprise Parylene C and the second layer may comprise Parylene N. In some embodiments, the first layer may consist, or essentially consist of Parylene C. In some embodiments, the second layer may consist, or essentially consist of Parylene N. In some embodiments, the first layer may comprise Parylene N and the second layer may comprise Parylene C.

In some embodiments, a hard coating may be additionally provided on the razor blade. The hard coating may improve the razor blades hardness, in turn increasing the blade's durability, in particular its useful life. In some embodiments, the hard coating may comprise a ceramic, a metal and/or a non-metallic coating. In some embodiments, the ceramic may comprise a boride and/or a carbide and in particular titanium diboride. In some embodiments, the ceramic may comprise titanium, boron and carbon. In some embodiments, the metal of the hard coating may comprise chromium. In some embodiments, the non-metallic coating may comprise diamond-like-carbon.

When referring to a hard coating, it should be understood that the coating as such may be harder than the coated cutting edge portion and/or that the coated cutting edge portion may be hardened in its entirety in comparison to an uncoated substrate portion. The hardness of the hard coating or coated cutting edge portion may be determined by using a nanoindenter. During the nanoindentation process, a hard tip whose properties (mechanical properties, geometry, tip radius etc.) are known, penetrates the hard coating sample to be analyzed. For example, a Berkovich tip may be used for the indentation tests. The load enforced on the indenter tip was increased as the tip penetrated further into the specimen until penetration depth of 50-100 nm was reached. At this point, the load was held constant for a period of time and then the indenter was removed. The area of the residual indentation in the sample was measured. The hardness H is defined as the maximum load $\mathbf{P_{max}}$ divided by the residual indentation area A:

$$H = \frac{Pmax}{A}$$

In some embodiments, the hard coating or the cutting edge portion may exhibit a hardness between about 5 GPa to about 30 Gpa, more specifically between about 10 Gpa to about 20 Gpa.

The Parylene N and Parylene C may exhibit low adhesion to the razor blade or to the hard coating. Thus, the adhesion may be improved by the provision of a capping layer. It has been surprisingly found that Parylene N and Parylene C show good adhesion to titanium. It should be noted, that perfluoro- or a polyfluoroalkyl substance (PFAS) such as polytetrafluoroethylene (PTFE) do not show proper adhesion to titanium. Further, it has been surprisingly found that titanium as a capping layer may result in a reduced required cutting force compared to chromium. Accordingly, in some embodiments, a capping layer may be provided on the razor blade. In some embodiments, the capping layer may be disposed between the hard coating and the lubrication layer. In some embodiments, the capping layer may comprise a metal, even more specifically the capping layer may comprise chromium or titanium and even more specifically the capping layer may comprise titanium, in particular metallic titanium. In case the capping layer comprises chromium, it may also be in the form of metallic chromium. In some embodiments, the capping layer may consist, or essentially consist of titanium (as detailed above). The term "metallic titanium" is well known and i.a. attributed its common meaning in the art. additionally or alternatively, the term "metallic titanium" may relate to a reduced state of titanium wherein its oxidation number is 0. Additionally or alternatively, the term "metallic titanium" may relate to the titanium atoms comprised in the capping layer forming metallic bonds with one another.

In some embodiments, the lubrication layer may

form the outer most layer provided on the razor blade, in particular the second layer comprising Parylene N may form the outer most layer provided on the razor blade. Accordingly, the first layer may be provided closer to the razor blade than the second layer and the hard coating may be disposed closer to the razor blade than the first layer. In some embodiments, the first layer may be disposed on the capping layer and the second layer may be disposed on the first layer.

In some embodiments, the capping layer may be disposed directly on the razor blade and the lubrication layer may be disposed on the capping layer. In some embodiments, the capping layer may be disposed directly on the razor blade, the first layer may be disposed on the capping layer and the second layer may be disposed on the first layer. In these cases, the razor blade may not comprise a hard coating.

In some embodiments, the capping layer may have a thickness between about 5 nm to about 70 nm, more specifically between about 10 nm to about 60 nm and in particular between about 20 nm to about 50 nm.

In some embodiments, the lubrication layer may have a thickness between about 0.005 μm to about 5 μm, more specifically between about 0.02 μm to about 2 μm and in particular between about 0.1 μm to about 1 μm.

In some embodiments, the lubrication layer may comprise less than 1 wt.-%, more specifically less than 0.1 wt.-% and in particular no or substantially no polytetrafluoroethylene (PTFE) or any other perfluoro- or a polyfluoroalkyl substance (PFAS). As mentioned above, the lubrication layer comprising Parylene N and Parylene C may be used to replace lubrication coatings comprising PTFE (or any other PFAS). Further, as mentioned above, the lubrication layer can be applied by thin film deposition technologies, as opposed to PTFE coatings which require a spraying step. Thin film deposition technologies may allow depositing layers of greater uniformity compared to spraying. Additionally, thin film deposition technologies may allow depositing layer with less defects compared to spraying. Accordingly, in some embodiments, the lubrication layer may comprise no holes, in particular no holes with a diameter of between about 5 nm to about 200 nm.

Some hard coatings, in particular hard coatings comprising a ceramic, may exhibit improved adhesion to the razor blade, when an intermediate layer binds the hard coating to the razor blade. Accordingly, in some embodiments, the razor blade may comprise an intermediate layer between the hard coating and the razor blade. In some embodiments, the intermediate layer may comprise a metal, more specifically niobium and/or titanium, even more specifically titanium and in particular metallic titanium. In case the intermediate layer comprises niobium, it may also be in the form of metallic niobium. In some embodiments, the intermediate layer may consist, or essentially consist of titanium or niobium, in particular titanium (as detailed above).

In some embodiments, the intermediate layer may be provided directly on the razor blade. Alternatively, in some embodiments, the hard coating may be provided directly on the razor blade.

Fig. 1 shows the cutting edge portion 100 of a first exemplary razor blade 10 according to the first aspect. On the cutting edge portion 100, a first layer 102 comprising Parylene C is provided. A second layer 104 comprising Parylene N is provided on the first layer 102, in particular as the outer most layer provided on the razor blade 10.

Fig. 2 shows the cutting edge portion 200 of a second exemplary razor blade 20 according to the first aspect. On the cutting edge portion 200, an intermediate layer 206 is provided, on which a hard coating 208 is provided. The hard coating 208 of the exemplary razor blade 20 may be in particular a ceramic. On the hard coating 208, a capping layer 210 comprising titanium is provided. A first layer 202 comprising Parylene C is then provided on the capping layer 210. A second layer 204 comprising Parylene N is then provided on the first layer 202, in particular as the outer most layer.

Fig. 3 shows the cutting edge portion 300 of a third exemplary razor blade 30 according to the first aspect. On the cutting edge portion 300, a capping layer 310 is directly provided. Some hard coatings, for example chromium or titanium, may not require an intermediate layer. On the capping layer 310, a first layer 302 comprising Parylene C is provided. On the first layer 302, second layer 304 comprising Parylene N is provided.

As will be explained in more detail below, the lubrication layer, in particular the Parylene N and Parylene C, can be applied by thin film deposition technologies. In particular, the lubrication layer may be deposited by chemical vapor deposition. As a result, the lubrication layer can be applied to relatively small blade edge portions. In particular, the lubrication layer may be applied to smaller blade edge portions compared to the conventional PTFE coatings prepared by spraying. Smaller blade edge portions may reduce the cutting force needed during the shaving action. Accordingly, in some embodiments, the cross-section of the cutting edge portion may have a substantially symmetrical tapering geometry terminating in a blade tip, wherein the cross-section may have a central longitudinal axis originating from the blade tip, and wherein the cutting edge portion may have a thickness of between 1.5 μm and 2.4 μm measured at a distance of 5 μm along the central longitudinal axis from the blade tip. In some embodiments, the blade's edge portion has a thickness of between about 4.6 μm and about 6.8 μm, in particular about 4.62 to about 6.74 μm, measured at a distance of about 20 μm along the central longitudinal axis from the blade tip. In some embodiments, the blade's edge portion has a thickness of between about 10.3 μm and 14.4 μm, in particular about 10.32 to about 14.35 μm, measured at a distance of about 50 μm along the central longitudinal axis from the blade tip. In some embodiments, the blade's edge portion has a thickness of between about 19.8 μm and

27.6 μm, in particular about 19.82 to about 27.52 μm, measured at a distance of about 100 μm along the central longitudinal axis from the blade tip.

The above-described razor blades can be manufactured by any suitable means. More specifically, the preparation and grinding of the blade substrate can be performed by any suitable means, for instance as disclosed in US 2017/136641 A1 which is incorporated by reference in its entirety.

In a second aspect, the present disclosure relates to a razor cartridge comprising at least one razor blade according to the first aspect. As mentioned above, the lubrication layer may be in particular beneficial for razor blades for razor cartridges.

In a third aspect, the present disclosure relates to a method for coating a razor blade, wherein the method comprises coating a razor blade with Parylene C, more specifically by chemical vapor deposition, and coating the razor blade with Parylene N, more specifically by chemical vapor deposition.

Examples of a CVD technology include Low Pressure CVD (LPCVD), Atmospheric Pressure CVD (APCVD), Atomic Layer Deposition (ALD), and Metalorganic CVD (MOCVD) using precursors.

In some embodiments, coating the razor blade with Parylene C may be performed prior to coating the razor blade with Parylene N.

In some embodiments, the method may comprise coating the razor blade with titanium prior to coating the razor blade with Parylene C and/or Parylene N. In some embodiments, coating the razor blade with titanium may be performed by sputtering. In some embodiments, coating the razor blade with a capping layer comprising titanium may be performed by in particular, DC Sputtering, RF Sputtering, Closed Field Unbalanced Magnetron Sputtering (CFUMS), Ion Beam Sputtering, Cathodic Arc Deposition, and High-Power Impulse Magnetron Sputtering (HiPIMS) using sintered titanium targets in an Ar atmosphere.

In some embodiments, coating the razor blade with Parylene C by chemical vapor deposition may comprise the steps of sublimating a dimer of a Parylene C precursor, pyrolyzing the sublimated dimer of a Parylene C precursor to attain Parylene C precursor monomers, and depositing the Parylene C precursor monomers on the razor blade, in particular such that the Parylene C precursor monomers polymerize. The Parylene C precursor monomers may polymerize on the razor blade during or following the deposition. The polymerization of the Parylene C precursor monomers may lead to the formation of a Parylene C layer.

In some embodiments, sublimating the dimer of a Parylene C precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a Parylene C precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the Parylene C precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, the method may comprise a film-growth step following the deposition of the Parylene C precursor monomers, wherein film-growth step is performed at a temperature of between about 50 °C to about 100°C, more specifically between about 60 °C to about 80 °C, and/or at a pressure of between about 0.0001 Torr to about 0.05 Torr, more specifically between about 0.0005 Torr to about 0.002 Torr. The film-growth step may improve the polymerization of the Parylene C precursor monomers deposited on the razor blade.

In some embodiments, coating the razor blade with Parylene N by chemical vapor deposition may comprise the steps of sublimating a dimer of a Parylene N precursor, pyrolyzing the sublimated dimer of a Parylene N precursor to attain Parylene N precursor monomers, depositing the Parylene N precursor monomers on the razor blade, in particular such that the Parylene N precursor monomers polymerize. The Parylene N precursor monomers may polymerize on the razor blade during or following the deposition. The polymerization of the Parylene N precursor monomers may lead to the formation of a Parylene N layer.

In some embodiments, sublimating the dimer of a Parylene N precursor may be performed at a temperature between about 130 °C to about 190 °C, more specifically between about 150 °C to about 180 °C, and/or at a pressure of between about 0.5 Torr to about 2 Torr, more specifically between about 0.8 Torr to about 1.2 Torr.

In some embodiments, pyrolyzing the sublimated dimer of a Parylene N precursor may be performed at a temperature of between about 400 °C to about 800°C, more specifically between about 500 °C to about 700 °C, and/or at a pressure of between about 0.2 Torr to about 1 Torr, more specifically between about 0.4 Torr to about 0.6 Torr.

In some embodiments, depositing the Parylene N precursor monomers may be performed at a temperature of between about 10 °C to about 50°C, more specifically between about 17 °C to about 28 °C, and/or at a pressure of between about 0.01 Torr to about 0.5 Torr, more specifically between about 0.05 Torr to about 0.2 Torr.

In some embodiments, the method may comprise a film-growth step following the deposition of the Parylene N precursor monomers, wherein film-growth

step is performed at a temperature of between about 50 °C to about 100°C, more specifically between about 60 °C to about 80 °C, and/or at a pressure of between about 0.0001 Torr to about 0.05 Torr, more specifically between about 0.0005 Torr to about 0.002 Torr. The film-growth step may improve the polymerization of the Parylene N precursor monomers deposited on the razor blade.

In some embodiments, the method for coating a razor blade may further comprise an annealing step, in particular the razor blade may be annealed at a temperature between about 300 °C to about 400 °C, more specifically at a temperature between about 330 °C to about 370 °C in an inert gas atmosphere, in particular after deposition of the Parylene C and/or Parylene N, or if performed, after the film-growth step.

In some embodiments, the razor blade may be annealed for a duration between about 10 s to about 20 min, more specifically between about 1 min to about 5 min. If the annealing exceeds 20 minutes, the hardness and/or corrosion resistance of the razor blades may degrade. In some embodiments, the razor blade may be annealed in an inert atmosphere, more specifically a nitrogen or argon atmosphere. The annealing step may allow to reduce the required cutting force during the shaving action. Without wishing to be bound by theory, it is believed that the annealing may increase the crystallinity of the Parylene C and/or Parylene N, which may result in an increased strength of the parylene, which in turn may reduce the required cutting force. Further, the softening of the Parylene C and/or Parylene N during the annealing step may also further increase the uniformity of the lubrication layer. The annealing step may reduce the surface defects in the lubrication layer, e.g. reduce its porosity.

As mentioned above, a hard coating may be provided on the razor blade. Accordingly, the razor blade may be coated with a hard coating, in particular prior to being coated with the fist layer. The razor blade may be coated with a hard coating for example using chemical vapor deposition or physical vapor deposition process. Exemplary hard coating deposition processes are described in US 2018/215056 A1 and US 10,442,098 B2, both of which are incorporated by reference in their entirety.

As mentioned above, an intermediate layer and/or capping layer may be provided on the razor blade. Accordingly, the razor blade may be coated with an intermediate layer, in particular prior to being coated with the hard coating. Additionally or alternatively, the razor blade may be coated with a capping layer, in particular after being coated with the hard coating Accordingly, in some embodiments, coating the razor blade with the intermediate layer and/or capping layer, in particular an intermediate layer and/or capping layer comprising titanium, may be performed by sputtering. In some embodiments, coating the razor blade with an intermediate layer and/or capping layer may be performed by in particular, DC Sputtering, RF Sputtering, Closed Field Unbalanced Magnetron Sputtering (CFUMS), Ion Beam Sputtering, Cathodic Arc Deposition, and High-Power Impulse Magnetron Sputtering (HiPIMS) using sintered metal targes, in particular sintered titanium targets, in an Ar atmosphere.

## Experimental Section

### Sample Preparation

Three sample lots (first, second and third sample lots) according to the first aspect were prepared. Furthermore, three comparative sample lots (first, second and third comparative sample lots) not according to the first aspect were prepared as well.

### 1. First Comparative Sample Lot (Parylene C)

The first comparative sample lot comprising a capping layer comprising titanium and a second layer comprising Parylene-C was prepared. The first comparative sample lot was prepared by the following protocol: Ten stainless steel razor blades were stacked on blade carriers in a rotating fixture of a depositing chamber. The depositing chamber comprised a titanium target and a $TiB_2$ target. In case a chromium layer was also deposited, e.g. as a capping layer, the depositing chamber also comprised a chromium target.

A preparative sequence of steps was carried out before the deposition of the intermediate layer, to perform a sputter etching. The depositing chamber was evacuated up to a base pressure of 10-5 Torr using vacuum means. Then Ar gas was inserted from an Ar gas source into the chamber up to a pressure of 8 mTorr (8.10-3 Torr). The loaded bayonets were rotated in the rotating fixture at a constant speed of 6 rpm using a motor, all targets, and notably the Ti and $TiB_2$ targets were operated under DC current control at 0.2 Amps. A DC voltage of 200-600 V was applied on the stainless steel blades for 4 minutes. The sputter etching step aids in removing impurities from the blade substrates and the targets through bombardment of Argon ions.

Subsequently, the coating process itself was carried out.

In a first sequence of steps for the formation of an intermediate layer, the chamber pressure was adjusted to 3 mTorr. The Ti and $TiB_2$ target(s) were operated under DC current control at 3 and 0.2 Amps respectively while a DC voltage of 0-50 V was applied on the rotating blades. Adjusting the deposition time, a Ti layer of 20-40 nm was deposited on the edge of the blade samples.

In a second sequence of steps, a $TiB_2$ hard coating was deposited, after the deposition of the Ti interlayer. The hard coating deposition also took place at pressure of 3 mTorr. The Ti, Cr (if present), and $TiB_2$ targets were operated simultaneously, with the current on the Cr and Ti target set to 0.2 Amps, and the current on $TiB_2$ target set to 3 Amps. The current on the Ti and Cr

target was used to prevent elements from depositing on that target. A DC bias voltage of 150 to 350 V was applied on the rotating blades. Adjusting the deposition time, a $TiB_2$ layer of 150-300 nm was deposited on the Ti layer.

In a third sequence of steps, a capping layer was deposited on the hard coating. The capping layer deposition also took place at pressure of 3 mTorr. Then, the deposition of the capping layer comprising titanium took place, with the chamber pressure being adjusted to 3 mTorr. The titanium target was operated under DC current control at 3-10 Amps while a DC voltage of 0-50 V was applied on the rotating blades. Adjusting the deposition time, a titanium layer with a thickness of 20-40 nm was deposited on the razor blades.

In a fourth sequence of steps for the formation of the lubrication layer, the rotating fixture was transferred to a second deposition chamber comprising a vaporizer, a pyrolysis chamber, a deposition chamber, a cold trap and a mechanical vacuum pump. Subsequently, the second chamber was evacuated up to a base pressure of 1 Torr. Parylene C precursor dimers were vaporized at a temperature of 175 °C. Subsequently, the pressure in the chamber was reduced to 0.5 Torr and the Parylene C precursor dimers pyrolyzed to form Parylene C precursor monomers at a temperature of 680 °C. Subsequently, the formed Parylene C precursor-monomers were deposited at a temperature of 25 °C at a pressure of 0.1 Torr. The temperature was then raised to 70 °C at a pressure of 0.001 Torr.

In a fifth sequence of steps to anneal the razor blades the second chamber was filled with argon at atmospheric pressure and heated to a temperature of 350 °C for 10 minutes to anneal the razor blades. After cooling to room temperature, the finished razor blades (being the first comparative sample lot) were removed from the second chamber.

**2. Second Comparative Sample Lot (Parylene-N)**

The second comparative sample lot was prepared analogously to the first comparative sample lot, except that Parylene-N-precursor-dimers were used as opposed to Parylene-C-precursor-dimers in the fourth sequence of steps.

**3. Third Comparative Sample Lot (Parylene-F)**

The third comparative sample lot was prepared analogously to the first comparative sample lot, except that Parylene-F-precursor-dimers were used as opposed to Parylene-C-precursor-dimers in the fourth sequence of steps.

**4. First Sample Lot (Parylene-C+Parylene-N)**

The first sample lot according to the first aspect was prepared analogously to the first comparative sample lot, except that after deposition of the Parylene-C, the fourth sequence of steps was repeated using Parylene-N-precursor-dimers to deposit a first layer comprising Parylene-C and a second layer comprising Parylene-N.

**5. Second Sample Lot (Parylene-C+Parylene-N - no annealing)**

A second sample lot according to the first aspect was prepared by coating the razor blades the same as for the first sample lot according to the first aspect, however, the fifth sequence of steps was not performed. Hence, the second sample lot was not annealed.

**6. Third Sample Lot (Chromium+Parylene-C+Parylene-N)**

A third sample lot according to the first aspect was prepared analogously to the first sample lot according to the first aspect, except that the razor blade was coated with chromium instead of titanium in the third sequence of steps.

**Cutting Force Experiment**

The cutting force of the first, second, and third sample lot according to the first aspect, as well as of the first, second, and third comparative sample lot, were determined.

Ten blades per sample lot were each subjected to 10 consecutive cuts on a moving wool felt. The blades were individually placed in a holder connected to a load cell. The load cell was used to measure the load on the blade during the cutting action.

In the following the test results are presented in the Figures 4 to 6, which are labelled as follows. The "Y"-Axis shows the required cutting force in "kg", the "X"-Axis denotes the number of cuts. The first comparative sample lot is denoted by the letter "A", the second comparative sample lot is denoted by the letter "B" and the third comparative sample lot is denoted by the letter "C". The first sample lot according to the first aspect is denoted by the letter "D", the second sample lot according to the first aspect, is denoted by the letter "E" and the third sample lot according to the first aspect, is denoted by the letter "F".

**Fig. 4** shows a comparison of the cutting force of the first sample lot according to the first aspect with the first, second and third comparative sample lots. As shown in Fig. 4, the razor blades comprising a lubrication layer comprising Parylene-N (second comparative sample lot) exhibit a lower cutting force during the first cuts, however, the required cutting force increases with the number of cuts, until it is higher than that of the Parylene-C coated blades (first comparative sample lot). On the other hand, the Parylene-C coated blades (first comparative sample lot) exhibit a higher required cutting force during the first use. The razor blades comprising a lubrication layer comprising Parylene-F (third comparative sample lot)

exhibit a consistently higher required cutting force compared to the other parylenes

The razor blades of the first sample lot according to the first aspect (Parylene C + Parylene N) outperform the first, second and third comparative sample lots during all 10 cuts.

**Fig. 5** shows a comparison of the cutting force of the first sample lot according to the first aspect and the second sample lot according to the first aspect. As shown in Fig. 5 the annealed razor blades exhibit a significantly reduced cutting force compared to the non-annealed razor blades.

**Fig. 6** shows a comparison of the cutting force of the first sample lot according to the first aspect and the third sample lot according to the first aspect. As shown in Fig. 6, the razor blades comprising the capping layer comprising titanium exhibit a significantly reduced cutting force compared to the razor blades comprising the capping layer comprising chromium.

## Claims

1. A razor blade (10, 20, 30) with a lubrication layer provided thereon, **characterized in that** the lubrication layer comprises Parylene C and Parylene N, wherein the razor blade (10, 20, 30) comprises a cutting edge portion (100, 200, 300) and wherein the lubrication layer is provided on the cutting edge portion (100, 200, 300).

2. The razor blade (10, 20, 30) according to any preceding claim, wherein the razor blade (10, 20, 30) is configured to be disposed within a razor cartridge.

3. The razor blade (10, 20, 30) according to any preceding claim, wherein the lubrication layer comprises a first layer (102, 202, 302) and a second layer (104, 204, 304), wherein the first layer (102, 202, 302) comprises Parylene C and the second layer (104, 204, 304) comprises Parylene N.

4. The razor blade (10, 20, 30) according to any preceding claim, wherein a hard coating (208) is additionally provided on the razor blade (10, 20, 30), wherein the hard coating (208) comprises a ceramic, a metal and/or a non-metallic coating.

5. The razor blade (10, 20, 30) according to claim 4, wherein a capping layer (210, 310) is further provided on the razor blade (10, 20, 30), in particular wherein the capping layer (210, 310) is disposed between the hard coating (208) and the lubrication layer, more preferably wherein the capping layer (210, 310) comprises a metal, even more preferably wherein the capping layer (210, 310) comprises chromium or titanium and in particular wherein the capping layer comprises titanium.

6. The razor blade (10, 20, 30) according to claim 5, wherein the capping layer (210, 310) has a thickness between about 5 nm to about 70 nm, more preferably between about 10 nm to about 60 nm and in particular between about 20 nm to about 50 nm.

7. The razor blade (10, 20, 30) according to any preceding claim, wherein the lubrication layer has a thickness between about 0.005 $\mu$m to about 5 $\mu$m, more preferably between about 0.02 $\mu$m to about 2 $\mu$m and in particular between about 0.01 $\mu$m to about 1 $\mu$m.

8. The razor blade (10, 20, 30) according to any preceding claim, wherein the lubrication layer comprises no holes, in particular no holes with a diameter of between about 5 nm to about 200 nm.

9. The razor blade (10, 20, 30) according to any preceding claim, wherein the lubrication layer comprises less than 1 wt.-%, more preferably less than 0.1 wt.-% and in particular no or substantially no polytetrafluoroethylene.

10. The razor blade (10, 20, 30) according to any one of claims 4 to 9, wherein the razor blade (10, 20, 30) comprises an intermediate layer (206) between the hard coating (208) and the razor blade (10, 20, 30), wherein the intermediate layer (206) comprises a metal, more preferably niobium and/or titanium, even more preferably titanium and in particular metallic titanium.

11. The razor blade (10, 20, 30) according to any preceding claim, wherein the razor blade (10, 20, 30) comprises, essentially consists or consists of a metal, in particular a stainless steel.

12. The razor blade (10, 20, 30) according to any one of claims 1 to 11, wherein the cross-section of the cutting edge portion (100, 200, 300) has a substantially symmetrical tapering geometry terminating in a blade tip, wherein the cross-section has a central longitudinal axis originating from the blade tip, and wherein the cutting edge portion (100, 200, 300) has a thickness of between 1.5 $\mu$m and 2.4 $\mu$m measured at a distance of 5 $\mu$m along the central longitudinal axis from the blade tip.

13. A razor cartridge comprising at least one razor blade (10, 20, 30) according to any preceding claim.

14. A method for coating a razor blade (10, 20, 30), **characterized in that** the method comprises:

    - coating a razor blade (10, 20, 30) with Parylene C, more preferably by chemical vapor deposition, and

- coating the razor blade (10, 20, 30) with Parylene N, more preferably by chemical vapor deposition.

## Patentansprüche

1. Rasiererklinge (10, 20, 30) mit einer darauf bereitgestellten Gleitschicht, **dadurch gekennzeichnet, dass** die Gleitschicht Parylen C und Parylen N umfasst, wobei die Rasiererklinge (10, 20, 30) einen Schneidkantenabschnitt (100, 200, 300) umfasst und wobei die Gleitschicht auf dem Schneidkantenabschnitt (100, 200, 300) bereitgestellt ist.

2. Rasiererklinge (10, 20, 30) nach einem der vorstehenden Ansprüche, wobei die Rasiererklinge (10, 20, 30) konfiguriert ist, um innerhalb einer Rasiererkartusche angeordnet zu werden.

3. Rasiererklinge (10, 20, 30) nach einem der vorstehenden Ansprüche, wobei die Gleitschicht eine erste Schicht (102, 202, 302) und eine zweite Schicht (104, 204, 304) umfasst, wobei die erste Schicht (102, 202, 302) Parylen C umfasst und die zweite Schicht (104, 204, 304) Parylen N umfasst.

4. Rasiererklinge (10, 20, 30) nach einem der vorstehenden Ansprüche, wobei eine harte Beschichtung (208) auf der Rasiererklinge (10, 20, 30) zusätzlich bereitgestellt ist, wobei die Hartbeschichtung eine Keramik, ein Metall und/oder eine nichtmetallische Beschichtung umfasst..

5. Rasiererklinge (10, 20, 30) nach Anspruch 4, wobei eine Deckschicht (210, 310) ferner auf der Rasiererklinge (10, 20, 30) bereitgestellt ist, wobei die Deckschicht (210, 310) insbesondere zwischen der harten Beschichtung (208) und der Gleitschicht angeordnet ist, wobei die Deckschicht (210, 310) mehr bevorzugt ein Metall umfasst, wobei die Deckschicht (210, 310) noch mehr bevorzugt Chrom oder Titan umfasst und wobei die Deckschicht insbesondere Titan umfasst.

6. Rasiererklinge (10, 20, 30) nach Anspruch 5, wobei die Deckschicht (210, 310) eine Dicke zwischen etwa 5 nm bis etwa 70 nm, mehr bevorzugt zwischen etwa 10 nm bis etwa 60 nm und insbesondere zwischen etwa 20 nm bis etwa 50 nm aufweist.

7. Rasiererklinge (10, 20, 30) nach einem der vorstehenden Ansprüche, wobei die Gleitschicht eine Dicke zwischen etwa 0,005 μm bis etwa 5 μm, mehr bevorzugt zwischen etwa 0,02 μm bis etwa 2 μm und insbesondere zwischen etwa 0,01 μm bis etwa 1 μm aufweist.

8. Rasiererklinge (10, 20, 30) nach einem der vorstehenden Ansprüche, wobei die Gleitschicht keine Löcher, insbesondere keine Löcher mit einem Durchmesser von zwischen etwa 5 nm bis etwa 200 nm, umfasst.

9. Rasiererklinge (10, 20, 30) nach einem der vorstehenden Ansprüche, wobei die Gleitschicht weniger als 1 Gew.-%, mehr bevorzugt weniger als 0,1 Gew.-% und insbesondere kein oder im Wesentlichen kein Polytetrafluorethylen umfasst.

10. Rasiererklinge (10, 20, 30) nach einem der Ansprüche 4 bis 9, wobei die Rasiererklinge (10, 20, 30) eine Zwischenschicht (206) zwischen der harten Beschichtung (208) und der Rasiererklinge (10, 20, 30) umfasst, wobei die Zwischenschicht (206) ein Metall, mehr bevorzugt Niob und/oder Titan, noch mehr bevorzugt Titan und insbesondere metallisches Titan umfasst.

11. Rasiererklinge (10, 20, 30) nach einem der vorstehenden Ansprüche, wobei die Rasiererklinge (10, 20, 30) ein Metall, insbesondere einen rostfreien Stahl, umfasst, aus diesem im Wesentlichen aus diesem besteht oder aus diesem besteht.

12. Rasiererklinge (10, 20, 30) nach einem der Ansprüche 1 bis 11, wobei der Querschnitt des Schneidkantenabschnitts (100, 200, 300) eine im Wesentlichen symmetrische sich verjüngende Geometrie aufweist, die in einer Klingenspitze endet, wobei der Querschnitt eine zentrale Längsachse aufweist, die von der Klingenspitze ausgeht, und wobei der Schneidkantenabschnitt (100, 200, 300) eine Dicke von zwischen 1,5 μm und 2,4 μm aufweist, gemessen in einem Abstand von 5 μm entlang der zentralen Längsachse von der Klingenspitze.

13. Rasiererkartusche, umfassend mindestens eine Rasiererklinge (10, 20, 30) nach einem der vorstehenden Ansprüche.

14. Verfahren zum Beschichten einer Rasiererklinge (10, 20, 30),
**dadurch gekennzeichnet, dass** das Verfahren umfasst:

- Beschichten einer Rasiererklinge (10, 20, 30) mit Parylen C, mehr bevorzugt durch chemische Gasphasenabscheidung, und
- Beschichten der Rasiererklinge (10, 20, 30) mit Parylen N, mehr bevorzugt durch chemische Gasphasenabscheidung.

## Revendications

1. Lame de rasoir (10, 20, 30) avec une couche de lubrification fournie sur celle-ci, **caractérisée en ce que** la couche de lubrification comprend du Parylène C et du Parylène N, dans laquelle la lame de rasoir (10, 20, 30) comprend une partie de bord de coupe (100, 200, 300) et dans laquelle la couche de lubrification est fournie sur la partie de bord de coupe (100, 200, 300).

2. Lame de rasoir (10, 20, 30) selon l'une quelconque revendication précédente, dans laquelle la lame de rasoir (10, 20, 30) est conçue pour être disposée à l'intérieur d'une cartouche de rasoir.

3. Lame de rasoir (10, 20, 30) selon l'une quelconque revendication précédente, dans laquelle la couche de lubrification comprend une première couche (102, 202, 302) et une seconde couche (104, 204, 304), dans laquelle la première couche (102, 202, 302) comprend du Parylène C et la seconde couche (104, 204, 304) comprend du Parylène N.

4. Lame de rasoir (10, 20, 30) selon l'une quelconque revendication précédente, dans laquelle un revêtement dur (208) est également fourni sur la lame de rasoir (10, 20, 30), dans laquelle le revêtement dur (208) comprend une céramique, un métal et/ou un revêtement non métallique.

5. Lame de rasoir (10, 20, 30) selon la revendication 4, dans laquelle une couche de recouvrement (210, 310) est également fournie sur la lame de rasoir (10, 20, 30), en particulier dans laquelle la couche de recouvrement (210, 310) est disposée entre le revêtement dur (208) et la couche de lubrification, plus préférablement dans laquelle la couche de recouvrement (210, 310) comprend un métal, encore plus préférablement dans laquelle la couche de recouvrement (210, 310) comprend du chrome ou du titane et en particulier dans laquelle la couche de recouvrement comprend du titane.

6. Lame de rasoir (10, 20, 30) selon la revendication 5, dans laquelle la couche de recouvrement (210, 310) a une épaisseur comprise entre environ 5 nm et environ 70 nm, plus préférablement entre environ 10 nm et environ 60 nm, et en particulier entre environ 20 nm et environ 50 nm.

7. Lame de rasoir (10, 20, 30) selon l'une quelconque revendication précédente, dans laquelle la couche de lubrification a une épaisseur comprise entre environ 0,005 $\mu$m et environ 5 $\mu$m, plus préférablement entre environ 0,02 $\mu$m et environ 2 $\mu$m, et en particulier entre environ 0,01 $\mu$m et environ 1 $\mu$m.

8. Lame de rasoir (10, 20, 30) selon l'une quelconque revendication précédente, dans laquelle la couche de lubrification ne comprend aucun trou, en particulier aucun trou d'un diamètre compris entre environ 5 nm et environ 200 nm.

9. Lame de rasoir (10, 20, 30) selon l'une quelconque revendication précédente, dans laquelle la couche de lubrification comprend moins de 1 % en poids, plus préférablement moins de 0,1 % en poids et en particulier pas ou sensiblement pas de polytétrafluoroéthylène.

10. Lame de rasoir (10, 20, 30) selon l'une quelconque des revendications 4 à 9, dans laquelle la lame de rasoir (10, 20, 30) comprend une couche intermédiaire (206) entre le revêtement dur (208) et la lame de rasoir (10, 20, 30), dans laquelle la couche intermédiaire (206) comprend un métal, plus préférablement du niobium et/ou du titane, encore plus préférablement du titane et en particulier du titane métallique.

11. Lame de rasoir (10, 20, 30) selon l'une quelconque revendication précédente, dans laquelle la lame de rasoir (10, 20, 30) comprend, consiste essentiellement ou consiste en un métal, en particulier un acier inoxydable.

12. Lame de rasoir (10, 20, 30) selon l'une quelconque des revendications 1 à 11, dans laquelle la section transversale de la partie de bord de coupe (100, 200, 300) a une géométrie effilée sensiblement symétrique se terminant par une pointe de lame, dans laquelle la section transversale a un axe longitudinal central provenant de la pointe de lame, et dans laquelle la partie de bord de coupe (100, 200, 300) a une épaisseur comprise entre 1,5 $\mu$m et 2,4 $\mu$m mesurée à une distance de 5 $\mu$m le long de l'axe longitudinal central à partir de la pointe de lame.

13. Cartouche de rasoir comprenant au moins une lame de rasoir (10, 20, 30) selon l'une quelconque revendication précédente.

14. Procédé de revêtement d'une lame de rasoir (10, 20, 30), **caractérisé en ce que** le procédé comprend :

    - le revêtement d'une lame de rasoir (10, 20, 30) avec du Parylène C, plus préférablement par dépôt chimique en phase vapeur, et
    - le revêtement de la lame de rasoir (10, 20, 30) avec du Parylène N, plus préférablement par dépôt chimique en phase vapeur.

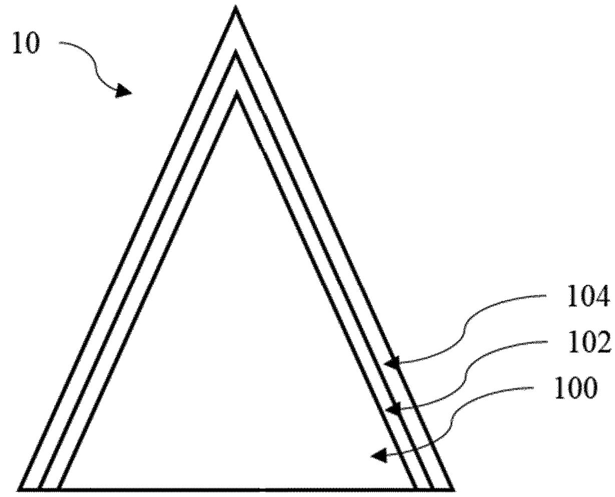


**Figure 1**

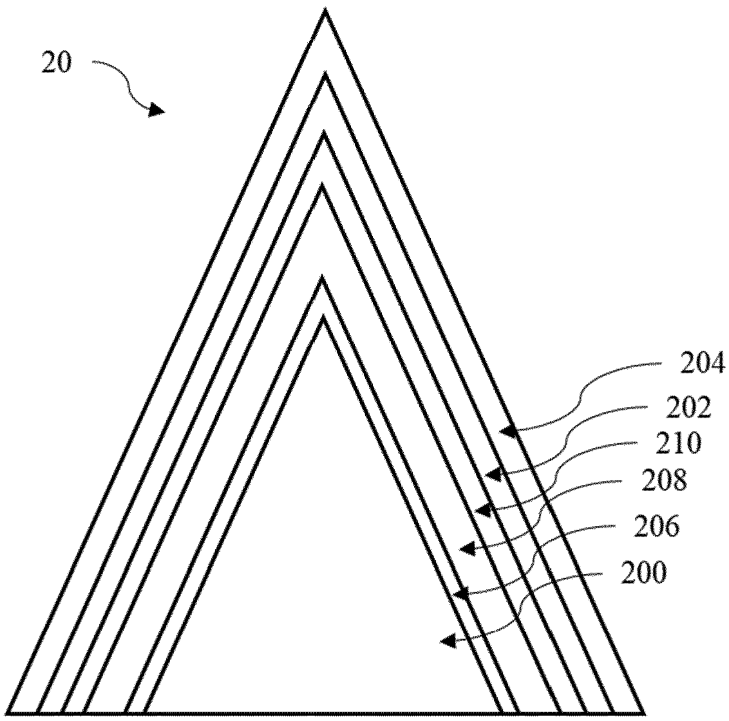


**Figure 2**

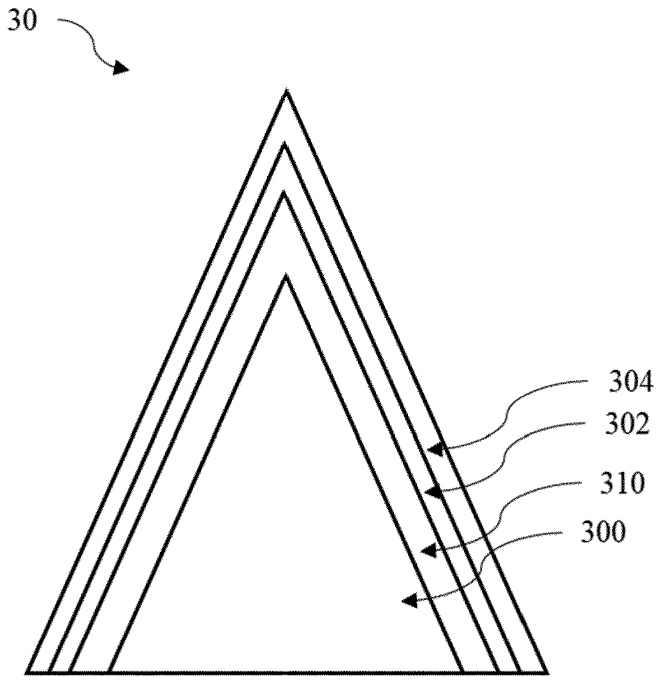


Figure 3

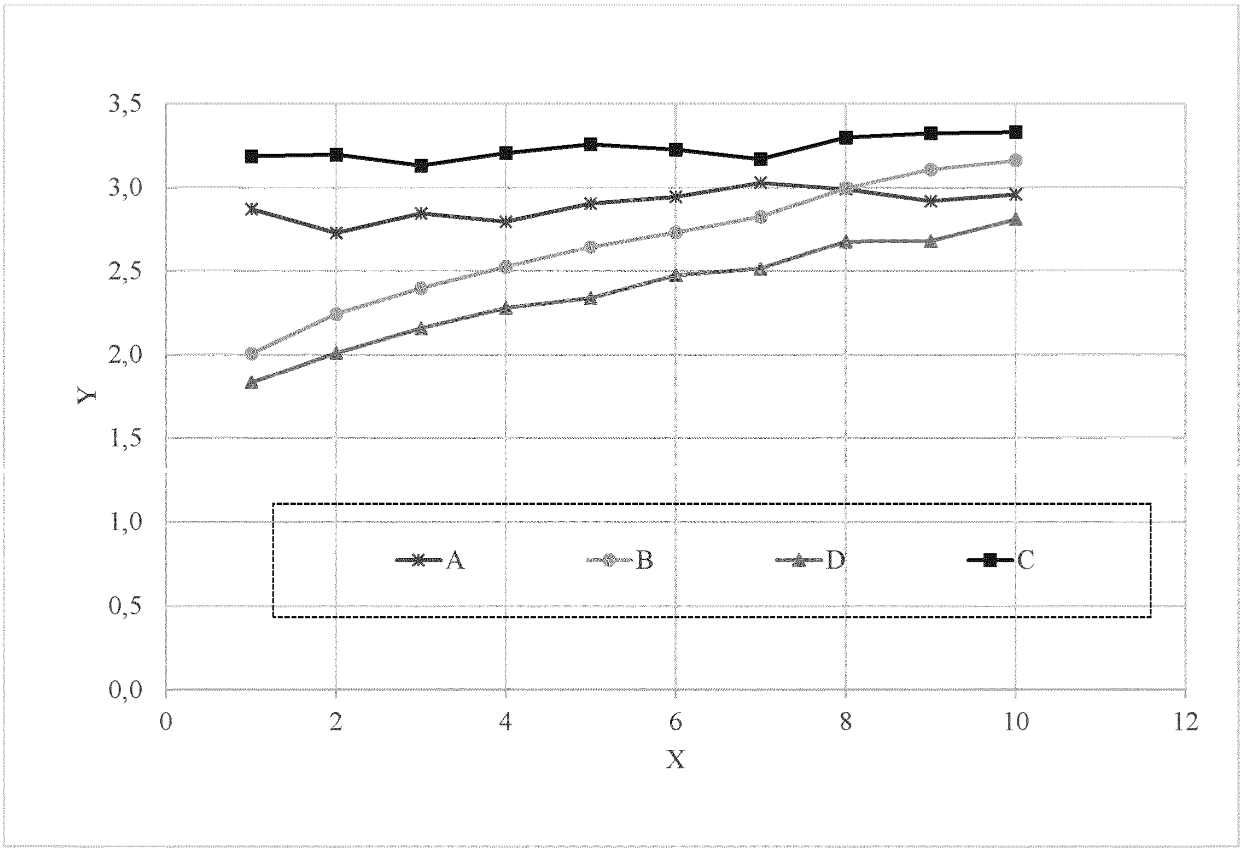


**Figure 4**

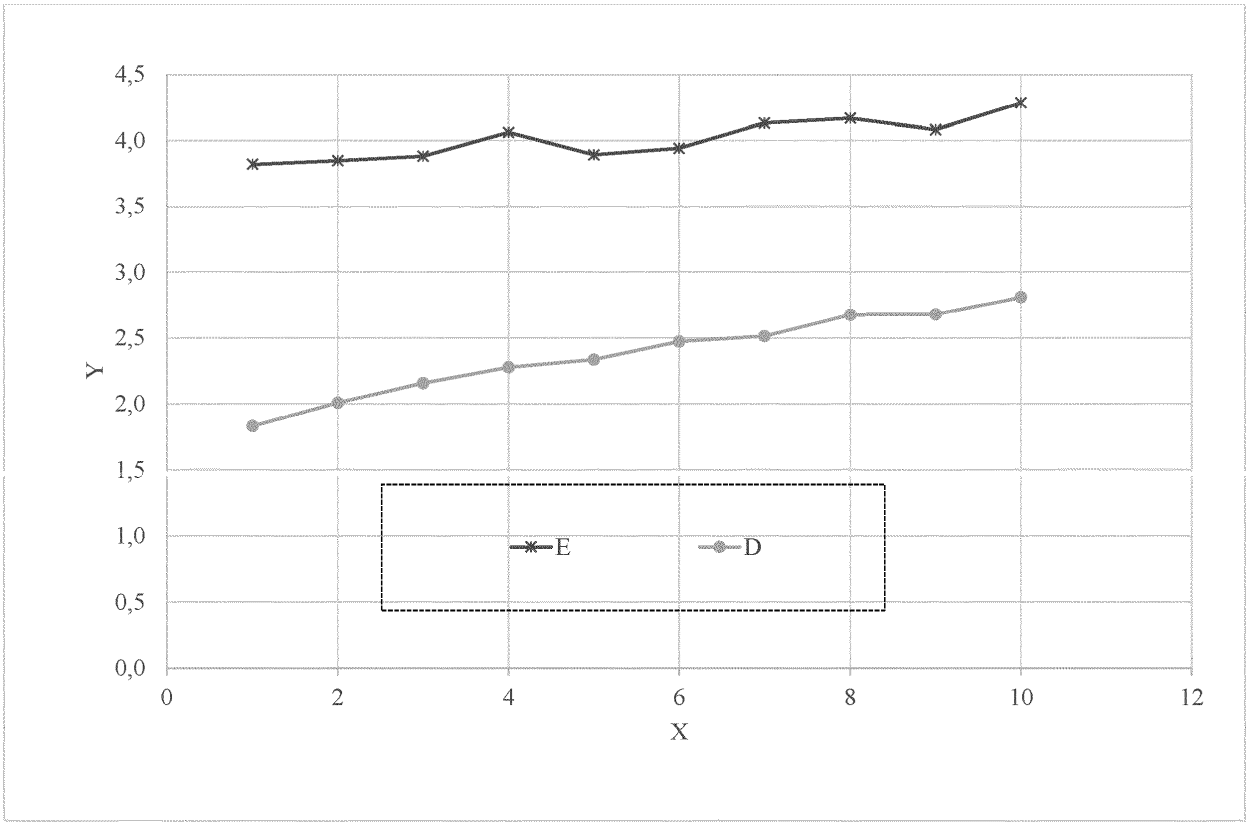


Figure 5

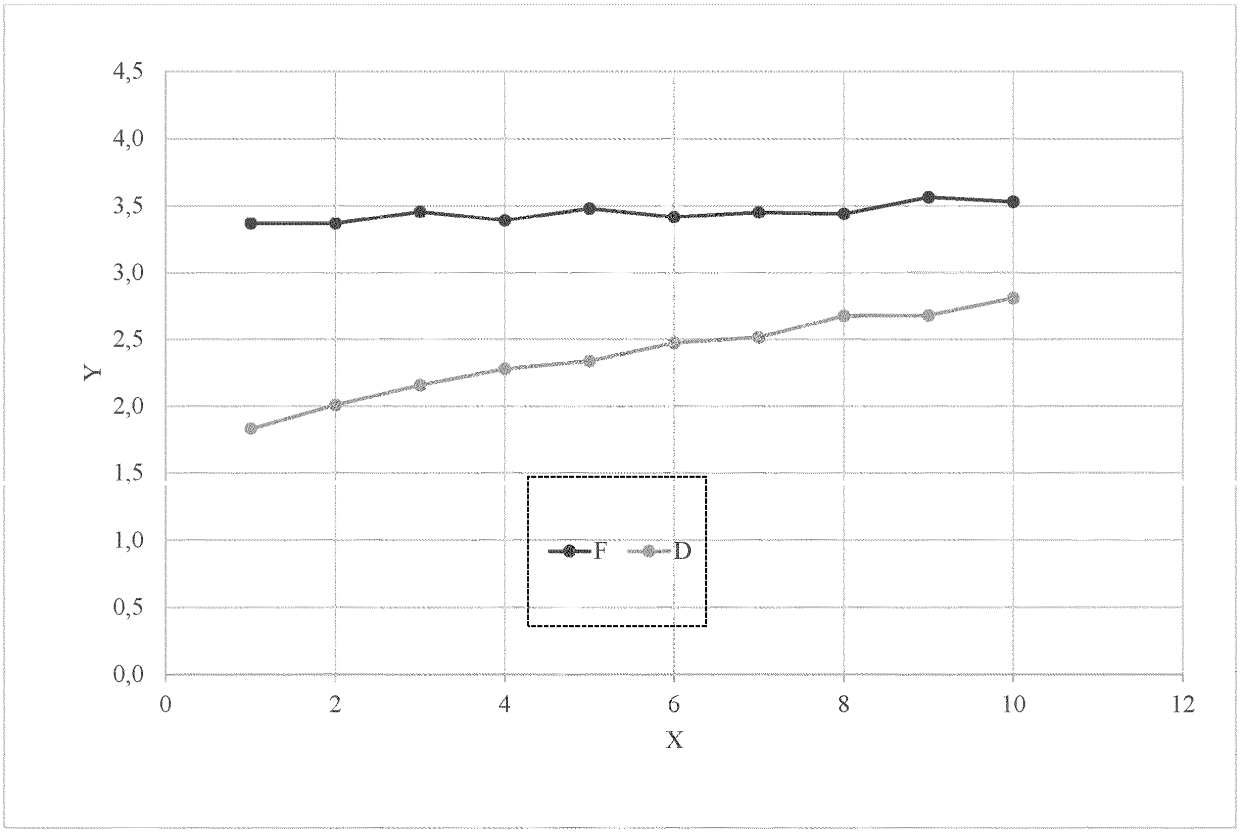


**Figure 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020316803 A1
- US 2017113359 A1
- US 4950365 A
- US 2023066180 A1
- US 5869135 A
- US 2017136641 A1
- US 2018215056 A1
- US 10442098 B2